# EUROPEAN PATENT SPECIFICATION

(11) **EP 4 237 653 B1**
(45) Date of publication and mention of the grant of the patent: **04.03.2026**
(21) Application number: 21884179.9
(22) Date of filing: 02.11.2021
(51) Int. Cl.: E21B 7/04, G01R 27/20, E21B 47/12, G01V 3/20, E21B 7/06, H01R 4/66, G01R 22/06

(54) **METHOD FOR INSTALLING AN EARTHING SYSTEM**
VERFAHREN ZUR INSTALLATION EINES ERDUNGSSYSTEMS
PROCÉDÉ D'INSTALLATION D'UNE MISE À LA TERRE

(30) Priority: 02.11.2020 AU 2020903990; 25.08.2021 AU 2021902748
(43) Date of publication of application: 06.09.2023
(73) Proprietor: McClure, Timothy Robert, Castlemaine, VIC 3450 (AU)
(72) Inventor: McClure, Timothy Robert, Castlemaine, VIC 3450 (AU)
(74) Representative: Pons IP
(86) International application number: PCT/AU2021/051290
(87) International publication number: WO 2022/087690

(56) References cited:
- WO-A2-2010/079888
- AU-A1- 2016 331 657
- CN-U- 208 111 707
- RU-C2- 2 181 918
- US-A- 4 786 874
- US-A- 6 064 210
- US-A1- 2007 205 022
- US-B2- 7 143 844
- "Earthing Techniques. Soil Resistivity Testing", 23 May 2006 (2006-05-23), pages 1 - 40, XP055131739, Retrieved from the Internet <URL:http://www.lightningman.com.au/Earthing.pdf> [retrieved on 20140725]

## Description

### PRIORITY DETAILS

The present application claims priority from AU 2020903990 and AU 2021902748.

### TECHNICAL FIELD

The present invention relates generally to the field of earthing systems, and specifically relates to a method for installing earth grounding. In particular, the invention relates to the installation of earth grounding in directionally drilled bores.

### BACKGROUND

In an electrical installation, an earthing system connects specific parts of that installation with the Earth's conductive surface either for safety/protective or functional purposes. Every electrically conductive surface in a structure must be grounded. This is achieved by connecting these conductive surfaces to a grounding system, which includes a grounding wire (which is usually protected by a green insulation sheath) and moves throughout the building and terminates at an earth electrode. In some arrangements, electrical power or signals are commonly transmitted via a pair of wires providing a complete circuit, or via an electrical cable likewise containing (at least) two conductors for that purpose. However, in alternate arrangements the power or signals are transmitted via a single-wire transmission line (or single wire method), which uses only a single electrical conductor. One further way of transmitting electrical power or signals is via a single-wire earth return (SWER) or single-wire ground return. The distinguishing feature of SWER is that the earth (or sometimes a body of water) is used as the return path for the current, to avoid the need for a second wire (or neutral wire) to act as a return path. Earthing is therefore critical in a SWER installation. SWER is a single-wire transmission line, which supplies single-phase electric power from an electrical grid (particularly) to remote areas at low cost. As such, SWER is principally used for rural electrification, but is also deployed for other applications.

Regarding earthing systems, reference is made to the non-patent literature document "Earthing Techniques. Soil Resistivity Testing", 23 May 2006 (2006-05-23), pages 1 - 40, XP055131739. Said document discloses earthing techniques comprising soil resistivity testing and analysis as well as design and testing of earthing systems, which includes the use of earth electrodes.

In simple installations, the earth electrode is a standard length of conductive copper in the form of a long metal spike, which binds all of these grounded parts to the soil so that any electrical discharges are channelled directly into the Earth. In these simple installations, the electrode is basically a metal spike that's hammered into the ground outside a home or other building. In other installations where more 'robust' solutions are required, typically a large pit or trench must be excavated. Within these pits or trenches, earthing plates, grounding rings and arrays of rods are utilised to ground the electrical circuits.

In either case, in order to be effective, the resistivity of the earthing electrode must be as close to zero ohms (0Ω) as possible. This is because electrical discharges always take the path of least resistance, so to ensure an earthing electrode functions correctly it must provide said path of least resistance. Because significant currents (in the order of 8 amperes) can flow through the ground near the earth points, a good-quality earth connection is needed to prevent risk of electric shock due to earth potential rise near these earthing points. In order to correctly install the earthing electrode following a conventional approach, soil resistivity is assessed first, a bore, trench, channel or other suitable 'opening' in the ground is excavated, and then the electrode plates and/or rods are configured in the ground pit or channel. In some cases, it may also be necessary to add low resistance compounds into the ground pit or channel (such as bentonite) as back-fill, which helps lower soil resistivity. Once the electrode has been installed in the ground pit or channel, the threading ground wire is bonded to the electrode(s). The ground pit, channel or ditch can then be covered, either with back-fill soil and/or with other soil additives as discussed above.

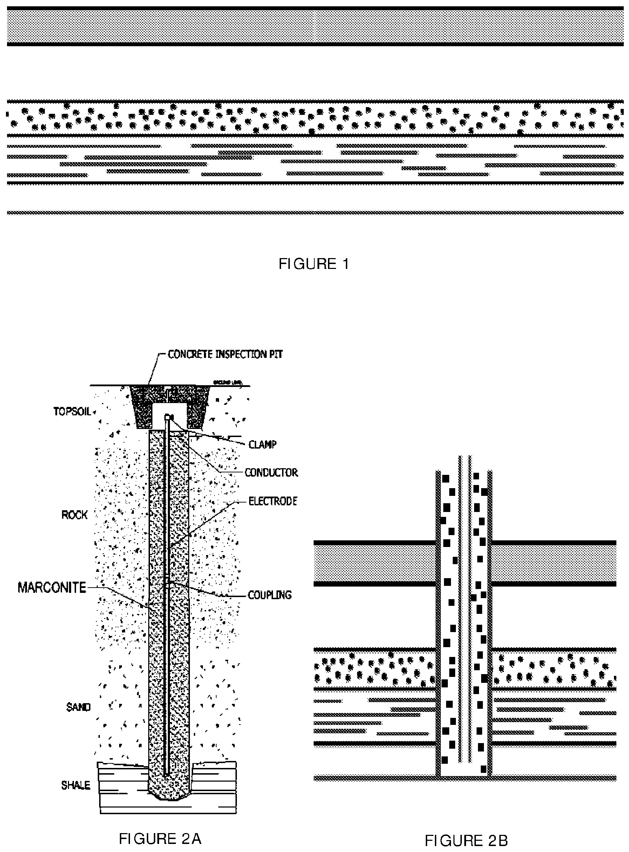

The primary characteristic that affects functionality of a given earth electrode is the ground material surrounding the electrode. The ground is typically comprised of a mixture of ground material, such as soil, dirt, gravel, rocks, agglomerate, plant matter and other material types, often broadly arranged in pockets, strata or layers. As is shown in Figure 1 (which is simplified for ease of understanding), the ground in which an electrode is installed for an earthing system may comprise a number of strata, or at the very least, different layers of ground material type, each of which may have approximately internally consistent characteristics that distinguish that particular stratum or layer from other distinct layers or strata. These layers are not necessarily horizontal with respect to the earth, and the interfaces between adjacent layers are not necessarily flat. Each 'layer' of ground material, having a particular composition, will have a resistivity, which is a measure of how much the ground material resists or conducts electric current. Importantly with respect to earthing systems, the resistivity of different strata layers can be different, and some layers may have favourable resistivity characteristics, whereas some layers may have unfavourable resistivity characteristics. Resistivity characteristics include the ground material type and composition, average ground temperature, moisture content, packing density (or conversely, aeration), each of which may either positively or negatively affect the ground material's resistance to flow of electricity therethrough. Where the resistivity of the soil is particularly high (which is not favourable for earthing systems), when following conventional installation methods, it may be necessary for the earthing system to incorporate multiple electrodes, or for the electrode to be of a substantial length (in some cases well over a hundred plus metres) in order to function effectively.

By way of example, patent documents WO2010079888A2 and RU2181918C2 can be found. The first document discloses an excavator for laying ground electrodes and a method for reducing ground resistance that uses said excavator. The invention disclosed by the first document consists of the excavator inserting a rod-shaped electrode stably without damage by embedding the electrode in a hollow portion inside a screw of the excavator. Also, said disclosure comprises reduction of ground resistance by using a ground resistance reducing material as a filling surrounding the space around the electrode and injecting said material without forming internal voids. The second document discloses a method for reducing resistance of ground elements in poorly conducting earth. The method comprises searching for a desired layer in permafrost earth for placing a ground electrode. The method further comprises making the search by using high-frequency electromagnetic probing from earth surface. Lastly, the method comprises placement of the ground electrode in the form of plate or disk in the layer by accessing through hole, trench, or well.

It can sometimes be beneficial for an earthing electrode to be installed horizontally. In these cases, the ground pit or channel that needs to be excavated may be over a few hundred metres in length in order for the electrode to be effective in grounding the electrical installation. This can be problematic as it can be difficult to keep such a ground pit or channel within designated easements and/or the ground pit or channel may destroy native vegetation or other cultural heritage areas. Similarly, pre-existing infrastructure may be in the way of any trenching or large-scale digging. In other words, there are often reasons why digging such a large/long trench can be problematic, meaning that horizontal installation of an earthing electrode using prior art methods is not always possible.

For example, patent document AU2016331657A1 discloses a method for monitoring earth composition surrounding a drill bit mounted on a drill-shaft during drilling of a borehole, that comprises vertical installation of an earth contacting down-hole electrode, as illustrated in Fig. 1 of the disclosure. The document also discloses monitoring of the electrical resistance through the earth between the earth contacting down-hole electrode, located at or adjacent the distal end of the drill-shaft, and a second electrode, located at a position remote from the first electrode, for example, at a surface location adjacent the drill head or in an adjacent borehole. Moreover, utility model CN208111707U can also be referred to as disclosing vertical installation of an earthing pole, as illustrated in Fig. 2 of the disclosure.

Therefore, it would be desirable for an alternate option to be provided. Given the time consuming process for expert electrical grounding fitters to prepare conventional earthing systems, and the drawbacks discussed above of such systems, there is a need to provide an alternate earthing system that overcomes, ameliorates or at least provides an alternative to prior art earthing systems.

### DISCLOSURE OF THE INVENTION

The scope of the invention is defined by the subject-matter of the claims.

There is described a method of installing an electrical earthing system in a region of ground, comprising the steps of:
I. determining a borehole site in the region of ground;
II. providing a drill string comprised of a conductive material and having a drill bit at an end thereof, and electrically connecting the drill string to an earth test terminal of a resistance testing apparatus;
III. electrically connecting a test electrode or electrodes to a remaining terminal or terminals of the resistance testing apparatus and placing the test electrode or electrodes in or on the ground within an area around the borehole;
IV. drilling the borehole using the drill string;
V. periodically or continuously measuring and recording a total electrical resistance using the resistance testing apparatus, and adjusting the drill string to reduce the total electrical resistance towards a target total electrical resistance;
VI. removing the drill rod from the borehole and disconnecting the drill string from the resistance testing apparatus;
VII. installing an earthing electrode within the borehole; and
VIII. backfilling the borehole with backfill ground material;
wherein the total electrical resistance is electrical resistance measured between a submerged portion of the drill string and the test electrode or electrodes.

In an embodiment, if, by step (VI), the total electrical resistance does not reach the target total electrical resistance, steps (I) - (VI) are repeated to drill a further borehole in the region of ground, a further earthing electrode is installed within the further borehole, which is then backfilled with ground material, total electrical resistance is electrical resistance measured between each of a conductive element in the first borehole and a further conductive element in the further borehole and the test electrode or electrodes, the conductive element is either the earthing electrode installed within the electrode or the submerged portion of the drill string, depending on if Step (VII) is executed for the borehole, and the further conductive element is either a submerged portion of the drill string within the further borehole, or a submerged portion of a further drill string, depending on if Step (VII) is executed for the borehole.

In an embodiment, the step of determining the borehole site comprises using the resistance testing apparatus to test ground electrical resistance at a plurality of sites within the region, using the ground electrical resistance to identify, from the plurality of sites within the region, at least one qualifying site, and selecting the borehole site from the at least one qualifying site or sites, wherein the qualifying or sites are identified by having favourable resistivity characteristics relative to other sites of the plurality of sites. In an embodiment, the borehole site is selected as the site having the most favourable resistivity characteristics of the plurality of sites.

In an embodiment, the drill bit is a directional drill bit, and during Step (IV), a direction of the drill bit is adjustable such that the borehole is able to be drilled to comprise consecutive portions thereof extending non-parallel to one another. In an embodiment, the borehole extends through a ground layer at an angle between -45° and +45° relative to horizontal (0°) for at least a portion of a length thereof. In an embodiment, the borehole is drilled such that at least a portion of a length of the borehole extends approximately parallel to a ground layer. In an embodiment, the ground layer is a region of in situ ground material having favourable resistivity characteristics.

In an embodiment, ground material extracted from the borehole during drilling is retained for use as least a portion of the backfill ground material. In an embodiment, the borehole is filled with backfill ground material and one or more additives.

In an embodiment when used to expand an existing earthing system, total electrical resistance is the electrical resistance measured between each of an earthing electrode of the existing earthing system and the submerged portion of the drill string and the test electrode or electrodes.

Other embodiments of the present invention may be disclosed herein or may become apparent to the skilled person through the disclosure. These and other embodiments are considered to fall within the scope of the present invention.

### DESCRIPTION OF FIGURES

Embodiments of the present invention will now be described in relation to figures, wherein:
Figure 1 depicts a cross-sectional view of the ground into which an electrode of a earthing system is to be installed, showing the different ground layers or strata layers;
Figures 2A & 2B depict an electrode of a prior art earthing system3
Figure 3 depicts an embodiment of the present invention;
Figure 4 depicts an embodiment of the present invention having a directional drill bit installed on the drill string;
Figure 5 is a comparative diagram of earth electrodes installed through a method of the present invention and through a prior art method;
Figure 6 is a graph of specific resistance vs. angle of inclination;
Figure 7 is a diagram of an electrode installed in an area of heavy infrastructure;
Figure 8 depicts an embodiment of the present invention being used to expand an existing earthing system;
Figure 9 depicts an embodiment of the present invention comprising multiple boreholes;
Figure 10 shows a photograph of a directional drill apparatus digging a borehole in the ground;
Figure 11 shows a photograph of the resistivity tester used to measure the ground resistivity in accordance with Step 2 of the present invention;
Figure 12 shows a photograph of the progressive measurements obtained from the resistivity tester of Figure 10;
Figure 13 shows a photograph of the drilling mud from the borehole;
Figure 14 shows a photograph of the drill rod (retracted from the borehole) and having an earth conductor (in the form of an earthing wire) with a loop at the bottom attached to the end of the drill rod for installation into the borehole; and
Figure 15 shows a photograph of an electrical pole with a completed earth grounding system installed by the method of the present invention.

### DEFINITIONS

As used herein, the term 'earthing electrode' should be understood to refer to metal conductors (or a combination of metal conductor types), which are buried or enclosed within ground material to provide an earth for an electrical system and can include rods or pipes driven into the ground, cables, stakes and wires or wire loops.

As used herein, the term 'ground material' should be understood to be the soil, dirt, gravel, rocks, agglomerate, plant matter and other material within the ground in the region.

### DETAILED DESCRIPTION OF PREFERRED EMBODIMENTS

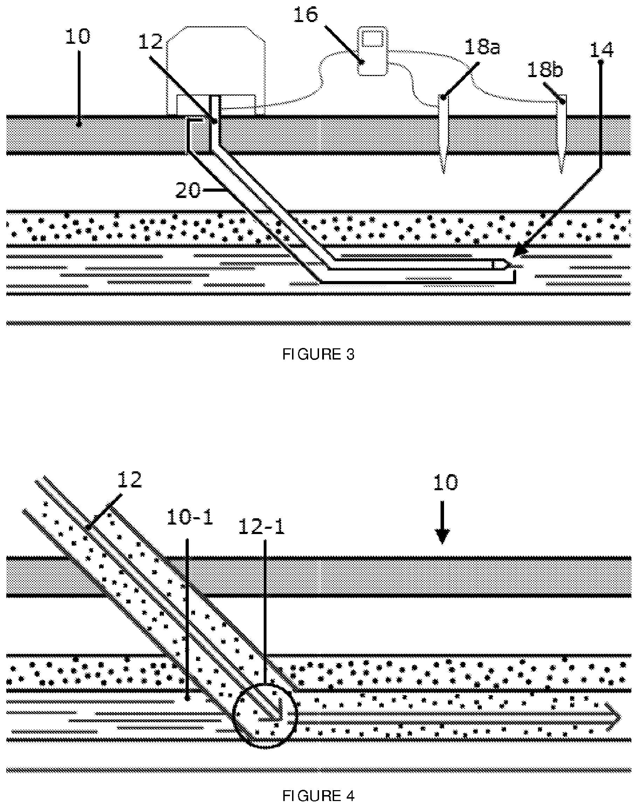

With reference to Figure 3, there is described a method of installing an electrical earthing system in a region of ground, comprising the steps of:
(1) determining a borehole site in the region of ground 10;
(2) providing a drill string 12 comprised of a conductive material and having a drill bit 14 at an end thereof, and electrically connecting the drill string to an earth test terminal of a resistance testing apparatus 16;
(3) electrically connecting a test electrode or electrodes 18a,b to a remaining terminal or terminals of the resistance testing apparatus 16 and placing the test electrode or electrodes in or on the ground 10 within an area around the borehole;
(4) drilling the borehole using the drill string and attached drill bit;
(5) periodically, or continuously, measuring and recording a total electrical resistance using the resistance testing apparatus and adjusting the drill string to reduce the total electrical resistance towards a target total electrical resistance;
(6) removing the drill rod from the borehole and disconnecting the drill string from the resistance testing apparatus;
(7) installing an earthing electrode within the borehole; and
(8) backfilling the borehole with ground material;
wherein the total electrical resistance is electrical resistance measured between a submerged portion 20 of the drill string and the test electrode or electrodes, and is not simply the electrical resistance between the drill bit and the test electrode or electrodes. The test electrode or electrodes 18a,b may be vertical test electrodes (for example, the test electrodes 18a,b depicted in Figure 3). Alternatively, the test electrode(s) may be horizontally-lain electrode(s), ball-shaped electrode(s), electrode spike(s) or any other test electrode design known in the art.

In an embodiment, the earthing electrode may be installed by attaching it to the end of the retracted drill string 12, and using the drill string to push the earthing electrode along the borehole. Such an embodiment is of use when the earthing electrode is a flexible cable as the drill string 12 can be used to guide the cable along the borehole length.

The skilled person will appreciate that the target total electrical resistance is at least partially determined based upon the properties of the electrical system or network for which the electrical earthing system of the present invention is being installed. In general, a lower total electrical resistance is more preferable to a higher total electrical resistance, and it is an object of at least one embodiment of the method of the present invention to provide a means of achieving a total electrical resistance that is substantially lower than that of an earth electrode that has been installed using a prior at method.

In an embodiment, the target total electrical resistance is preferably less than 100 ohms (Ω). More preferably, the target total electrical resistance is less than 50 Ω, less than 25 Ω, less than 10 Ω, or less than 5 Ω. The skilled person will appreciate that the efficiency of an earth electrode improves as total electrical resistance drops, and in a most preferred case wherein conditions are optimal, the target total electrical resistance may be less than 1 Ω, or even less than 0.5 Q. However, the skilled person will further appreciate that the minimum achievable total electrical resistance will depend upon the characteristics of the ground.

With return reference to Figure 1, as the borehole is drilled, it may pass into ground material having different resistivity characteristics, which will affect the overall performance of an earth electrode that is ultimately installed therein. Therefore, an embodiment of the present invention may be advantageous by testing the total electrical resistance of the earthing system *during* the drilling process, which is achieved by using the entire submerged portion 20 of the drill string 12 as the earth test electrode for testing with the resistance testing apparatus 16. This may enable the effect of a particular ground layer on the total electrical resistance to be identified and assessed during drilling. The skilled person will appreciate that this is different to the prior art methods wherein resistivity is measured solely between the prior art drill bit and testing electrodes, rather than the entire prior art drill string.

The total electrical resistance of the submerged portion 20 of the drill string 12 will decrease at a particular rate as the borehole length is increased. The rate of reduction in total electrical resistance (ΔR_{T}) is also dependent upon the resistivity characteristics of the ground material that the drill bit is currently drilling into. By periodically or continuously measuring the total electrical resistance, an operator can identify when the drill bit is within a ground layer having favourable resistivity characteristics, as the ΔR_{T} will increase. Conversely, the drill bit entering a ground layer with less favourable resistivity characteristics will be apparent as a *reduction* in ΔR_{T}.

The present invention may also enable a particular borehole to be adjusted, realigned abandoned, terminated, or otherwise reassessed if ground material with particularly unfavourable resistivity characteristics is encountered. For example, ground material with particularly unfavourable resistivity characteristics may mean that extending the borehole in a particular direction will provide limited reduction in total electrical resistance, i.e. the ΔR_{T} is lowered. In such a scenario, the drill string may be re-angled, relocated or otherwise adjusted such that the drilled borehole circumvents the ground material having unfavourable characteristics, or alternatively may drill therethrough to an adjacent ground layer having more favourable resistivity characteristics. Alternatively, upon encountering a ground layer having more favourable resistivity characteristics (i.e. noting that ΔR_{T} is increased), the drill string or drill bit may be adjusted such that the borehole extends further into the ground layer.

### Borehole Site Determination

In an embodiment, the step of determining the borehole site comprises:
(1) using the resistance testing apparatus 16 to test ground electrical resistance at a plurality of sites within the region;
(2) using the ground electrical resistance to identify, from the plurality of sites within the region, at least one qualifying site; and
(3) selecting the borehole site from the at least one qualifying site or sites.

In an embodiment, the qualifying site(s) is, or are, sites having favourable resistivity characteristics relative to the other site(s) within the region. This may be inferred, wherein a low ground electrical resistance value is considered indicative of favourable characteristics. Alternatively, soil resistivity may be more qualitatively calculated from the measured ground electrical resistance through one of the methods known in the art. The skilled person will appreciate that what would be considered favourable resistivity characteristics is highly dependent upon the local geographic and geological properties of the region, such as location, expected ground material types, as well as climate (humidity, rainfall, temperature, etc.), soil salt content and other factors. In other words, what may be favourable in one region characterised by soils having high resistivity may be considered less favourable in another that is characterised by an abundance of soils having a low resistivity.

In a further embodiment, the borehole site is selected as the site having the most favourable resistivity characteristics of the plurality of sites.

In an embodiment, ground material extracted from the borehole during drilling may be retained for use as backfill ground material, particularly if the retained ground material is determined to have favourable resistivity characteristics. In an embodiment, one or more additives such as soil stabilisers, wetting agents, or salts, may be added to the backfill ground material in order to improve the characteristics thereof.

### Directional Drilling

In an embodiment, the drill bit 14 is a directional drill bit, and during Step 4, a direction of the drill bit is adjustable such that the borehole is able to be drilled to comprise consecutive portions thereof extending non-parallel to one another. In a further embodiment, the borehole is drilled so as to extend through a ground layer at an angle between -45° and +45° relative to horizontal (0°) for at least a portion of a length thereof. As the skilled person may appreciate, ground layers tend to approximately extend in a planar fashion, although thickness may vary. The plane of a ground layer is also likely to be horizontal, or at least inclined less than 45° on average. It is therefore advantageous to provide a means of digging a borehole for receiving the earthing electrode that extends either horizontally, substantially parallel to a ground layer, or otherwise at an angle between -45° and +45° relative to horizontal.

In an embodiment wherein the drill bit 14 is a directional drill bit, the borehole is drilled such that at least a portion of a length of the borehole extends approximately parallel to a ground layer. In a further embodiment, the ground layer is a region of in situ ground material having favourable resistivity characteristics. One such embodiment is depicted in Figure 4, showing drill string 12 extending into the ground 10 and ultimately into favourable ground layer 10-1. With the periodic or continuous monitoring of the total electrical resistance by the resistance testing apparatus 16, a favourable ground layer 10-1 may be identified as a point when the rate of reduction in resistance (ΔR) increases in magnitude, labelled on Figure 4 as point 12-1. When the drill bit of the drill string 12 reaches point 12-1 and the increase in ΔR is identified, the drill bit 14 can be angled such that the borehole will subsequently extend parallel to favourable ground layer 10-1.

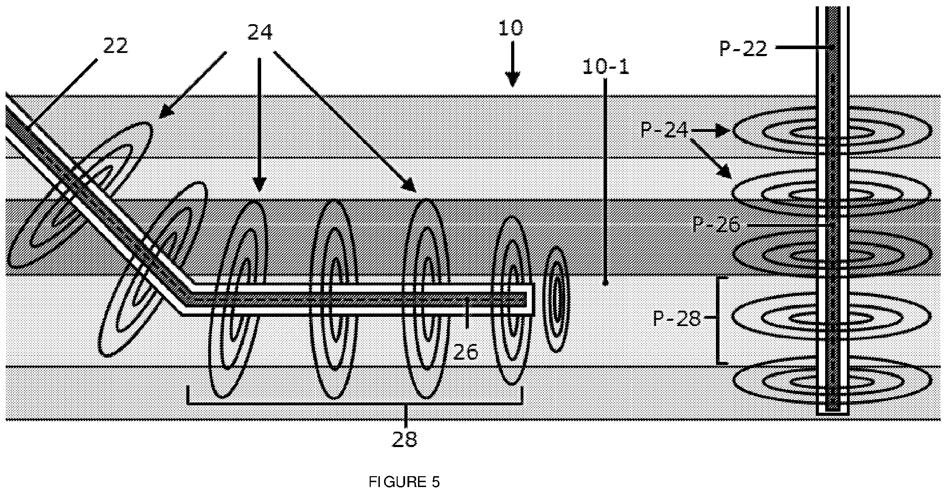

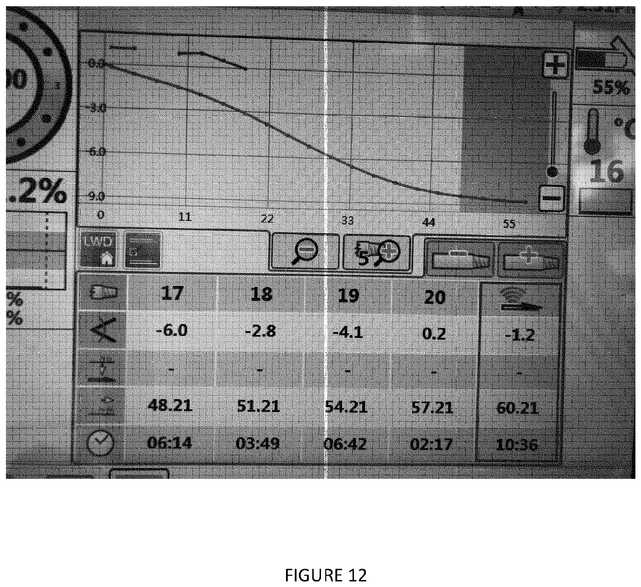

It is considered beneficial to provide a means of optimising ΔR, as an increase in ΔR means that a target total electrical resistance may be reached more efficiently and with a borehole of reduced length, leading to less material required to subsequently form the earth electrode. An example of this may be seen in the photograph of Figure 12, which depicts a recorded total electrical resistance over time. A first change in ΔR can be seen in the upper left of the graph shown in the photograph, where the magnitude of ΔR has increased due to the drill string 12 passing into a favourable ground layer 10-1. A second change in ΔR is visible in the bottom right, with a decrease in magnitude thereof. This may indicate that the drill string has exited the favourable ground layer 10-1, or drilling has slowed due to a maximum drill string length being approached. With reference to Figure 5, it is considered that an earth electrode 22 will emit electrical current in all directions, forming a radiating emission pattern 24. Figure 5 depicts a series of concentric circles to indicate how the emission pattern changes as the direction of the borehole and installed earth electrode 22 does. The skilled person will appreciate that the elements and concentric circles depicted in Figure 5 are for explanatory purposes only and therefore are not necessarily to scale, and that the concentric circles represent the "wavefront" of emitted electrical current. In other words, the emitted electrical current is travelling substantially perpendicular to the concentric circles of the radiating emission pattern 24. The skilled person will further appreciate that the earth electrode 22 acts as the 'axis' 26 of the emission patterns 24. Without limiting the scope of the invention through theory, it is considered that aligning at least a portion 28 of the axis 26 of the emission patterns 24 to be within and substantially parallel to favourable ground layer 10-1 may promote efficiency by increasing a surface area of the earth electrode 22 (i.e. where the emission patterns 24 radiate outwards from) exposed to the ground material of the favourable ground layer 10-1. As such, electricity can be emitted into, and propagate through, the favourable ground layer 10-1 with greater ease, reducing total electrical resistance.

This may be contrast against a traditional prior art earth electrode P-22 extending substantially vertically, also depicted in Figure 5. The prior art emission patterns P-24 are such that the electrical current is emitted in all horizontal directions, with the related axis P-26 extending substantially vertical - and thus perpendicular to the favourable ground layer 10-1. The portion P-28 of the prior art electrode P-22 that is located within the favourable ground layer 10-1 is substantially smaller than that of the electrode 22 installed using an embodiment of the method of the present invention. While the other layers of the ground 10 may also conduct electricity, they may be more resistant to electrical current flow than the favourable ground layer 10-1, and so portions of an earth electrode 22, P-22 within such a ground layer operate with less efficiency than the portion 28 within the favourable ground layer 10-1.

Through the method of the present invention, by continuously or periodically monitoring the total electrical resistance of the submerged portion of the drill string 12, the user is able to identify an optimum ground layer 10-1 and ensure that the borehole is drilled such that a greater proportion of the earth electrode 22 is installed within said optimum ground layer 10-1.

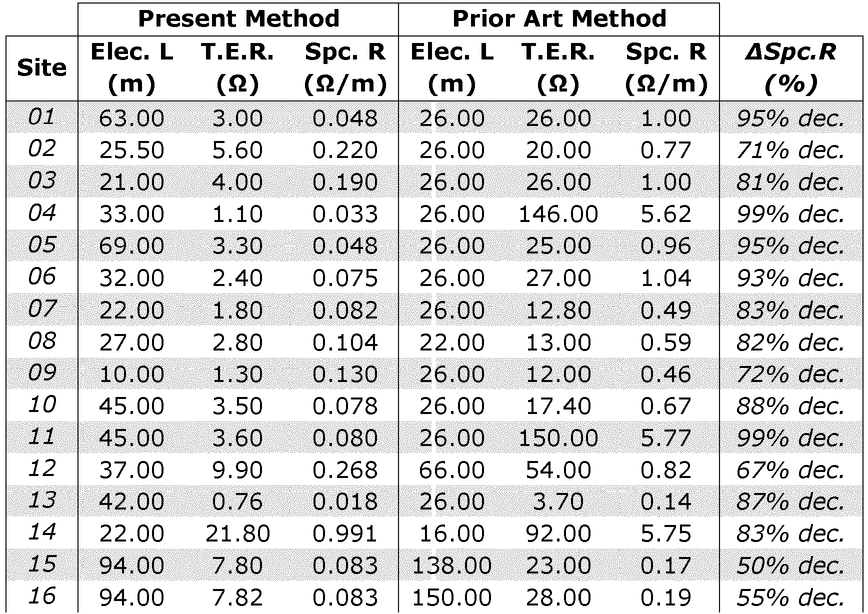

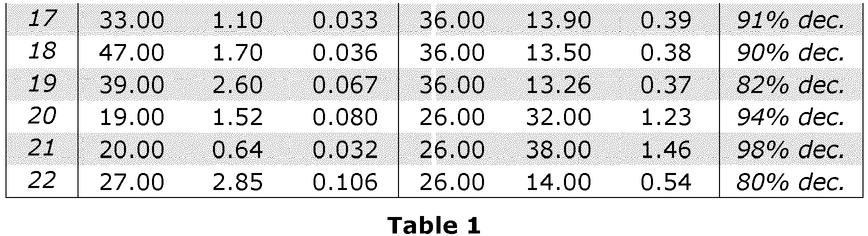

Table 1 above records the electrode length (in metres), the recorded total electrical resistance of the installed electrode (in Ohms), and the specific resistance (in Ohms per metre) for both an electrode installed using an embodiment of the method of the present invention, and an electrode installed using the conventional prior art method. The final column records the percentage reduction in specific resistance between the prior art method and an embodiment of the present method. As Table 1 illustrates, a substantially lower total electrical resistance of the electrode is able to be achieved using the method of the present invention. Additionally, the method of the present invention enables usage of an increased electrode length where it may be beneficial, such as if even the most favourable ground layers suffer from poor electrical conductivity. In contrast, the prior art method's electrode length is limited by how deep the electrode borehole is able to be dug, and what deep rock layers are present which may inhibit drilling.

Finally, the specific resistance - the resistance of any particular, specific portion of the installed electrode - is substantially lower for electrodes installed through the present method compared to the prior art 'vertical' method. It is considered that achieving a minimal specific resistance enables an electrode to operate at heavily increased efficiency. A minimised specific resistance means that any given surface area portion of the electrode 22 is able to emit electrical current into the ground at a higher rate. As electrode length is also partially determined by the amount of electrical current that needs to be grounded, improving specific resistance of the installed electrode enables an electrode to earth current at a greater rate than a comparative electrode of the same length but greater specific resistance - or alternatively, the same rate of current earthing can be achieved by an earth electrode of smaller length than the comparator. With reference to Table 2, the decrease in specific resistance is significant - indeed, surprisingly so. In some embodiments of the present invention, the method may provide at least a 50% decrease in specific resistance compared to the prior art method. Some embodiments may provide at least a 60% decrease, at least a 70% decrease, at least an 80% decrease or at least a 90% decrease in specific resistance.

In an embodiment wherein the drill bit 14 is a directional drill bit, the borehole is drilled such that at least a portion of a length of the borehole extends approximately parallel to an angle of inclination of a geomagnetic field of the region. It has been found that, particularly when an earth electrode is of a substantial length and all else being equal, there is a synergistic improvement in earth electrode performance when said earth electrode is approximately aligned with the local geomagnetic field.

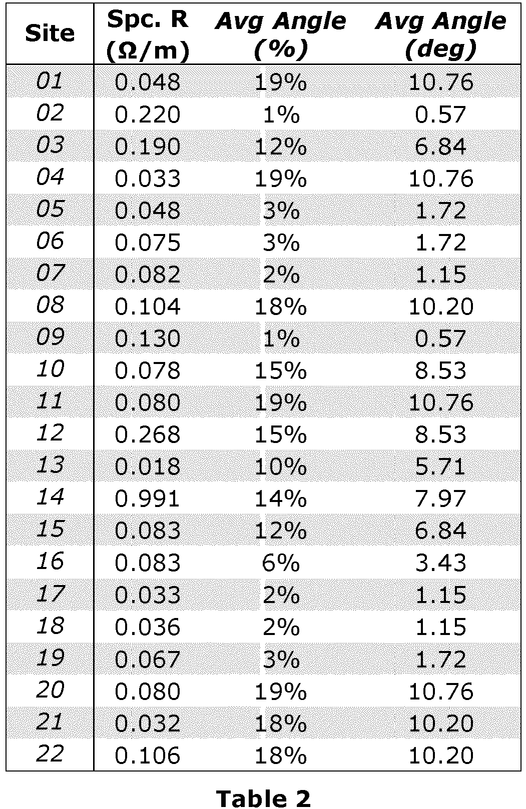

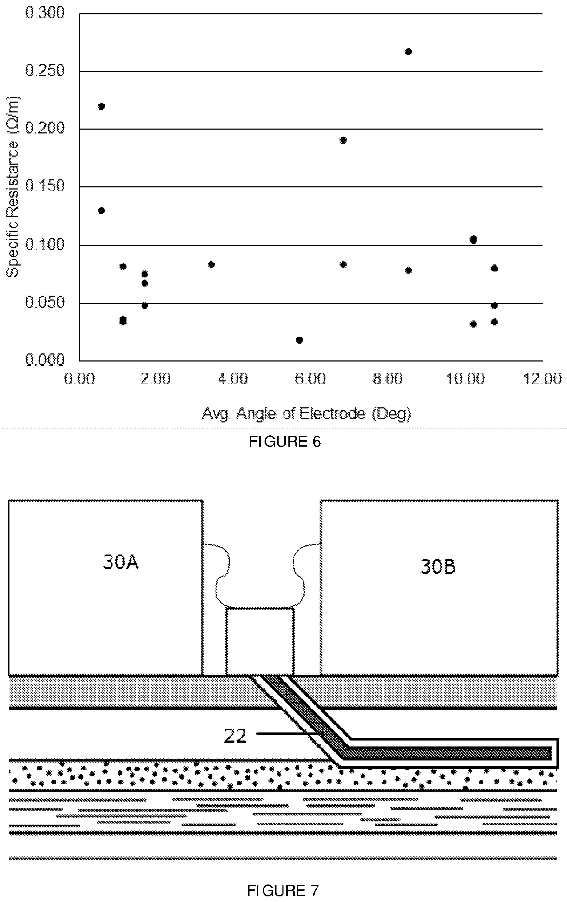

Table 2 above provides the average angle of the "horizontal" portion, or the portion aligned to the favourable ground layer 10-1, of the installed electrodes from Table 1. Each test site had an earth electrode installed in a borehole drilled with a directional drill bit, with the direction of the borehole adjusted to optimise specific resistance. Figure 6 depicts specific resistance plotted against the average angle of installation for the earth electrodes, with the value from Site 14 excluded as an outlier. As can be seen, there are two distinct clusters - one where the angle of installation is close to horizontal, and the second where the angle of installation is between -10° and -11°, and a range of values in between. As Table 2 and the graph of Figure 6 depict, the "horizontal portion" of the borehole are not necessarily exactly horizontal-rather, 'horizontal' as used herein refers to substantially aligning to the typically-substantially-horizontal ground layers, as opposed to a prior art electrode P-22 that is substantially vertical.

### Providing Earthing in Problematic Locations

Electrical systems require earthing. However, in some situations an earthing system may need to be installed in a built-up area, near a road, bridge or tunnel, in national parks, farms, or other areas where trenching would cause unacceptable disruptions, when a body of water is present or an upper ground layer is difficult to dig, or otherwise when trying to expand an already-present earthing system. In such a situation, an embodiment of the present invention may be further advantageous in that no trenching is required. The directional drill bit may enable the borehole to be extended under any existing infrastructure, difficult ground material, or other potential obstacles (such as trees, nesting sites, boulders, etc.) without requiring their disturbance. This will allow the efficient installation of suitable earthing systems in a variety of situations wherein it is too cost-, time-, or labour-intensive or otherwise difficult or impossible to install an earthing system through a prior art method.

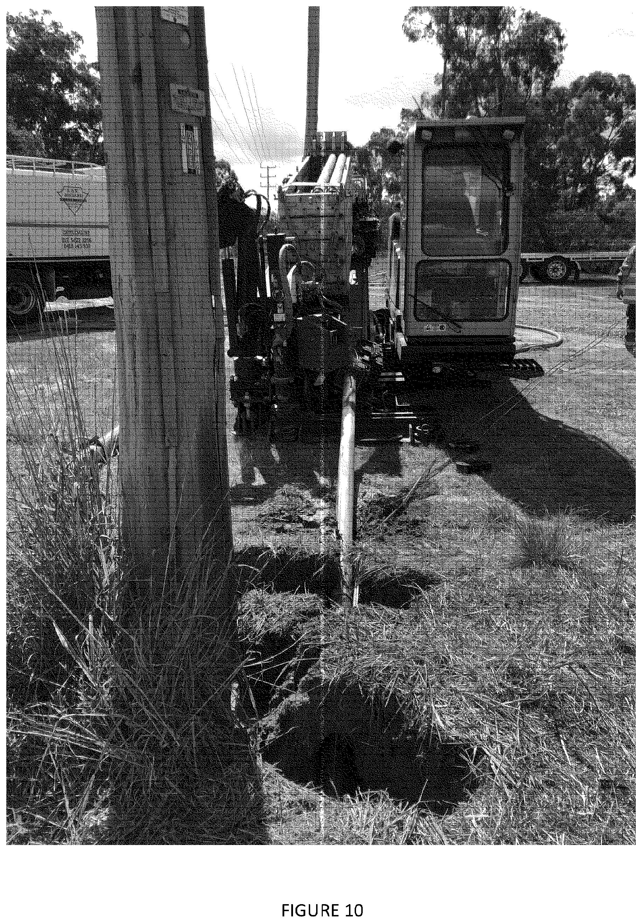

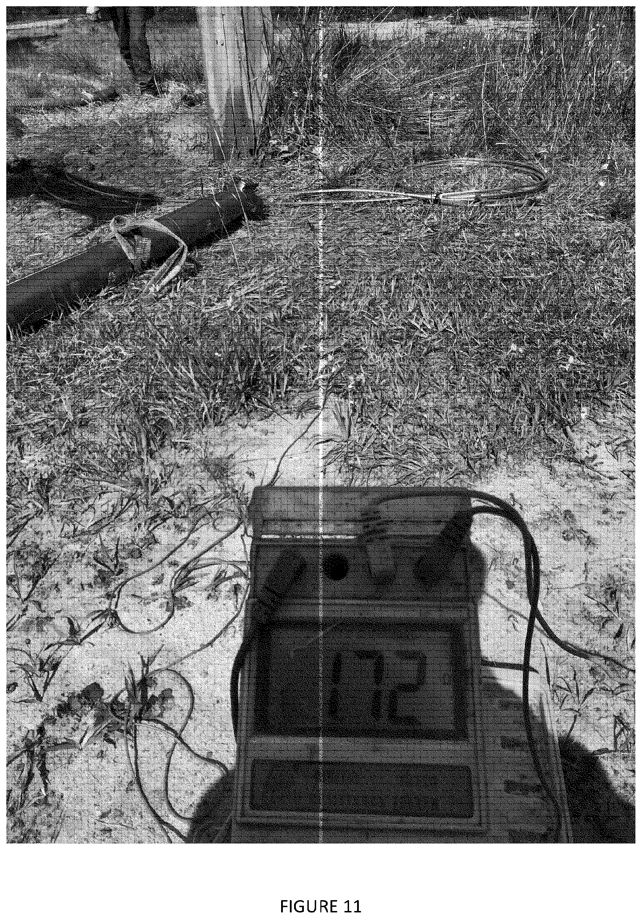

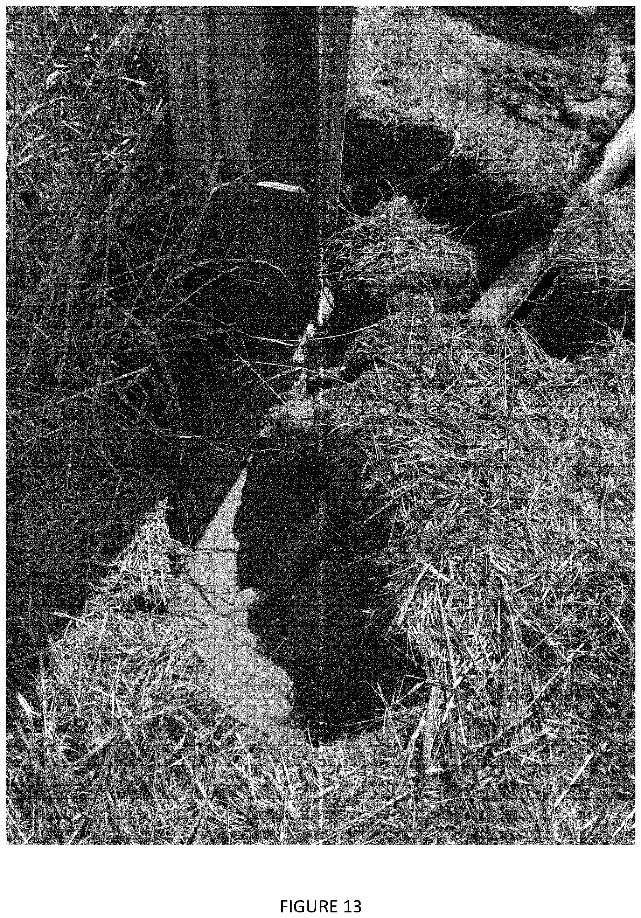

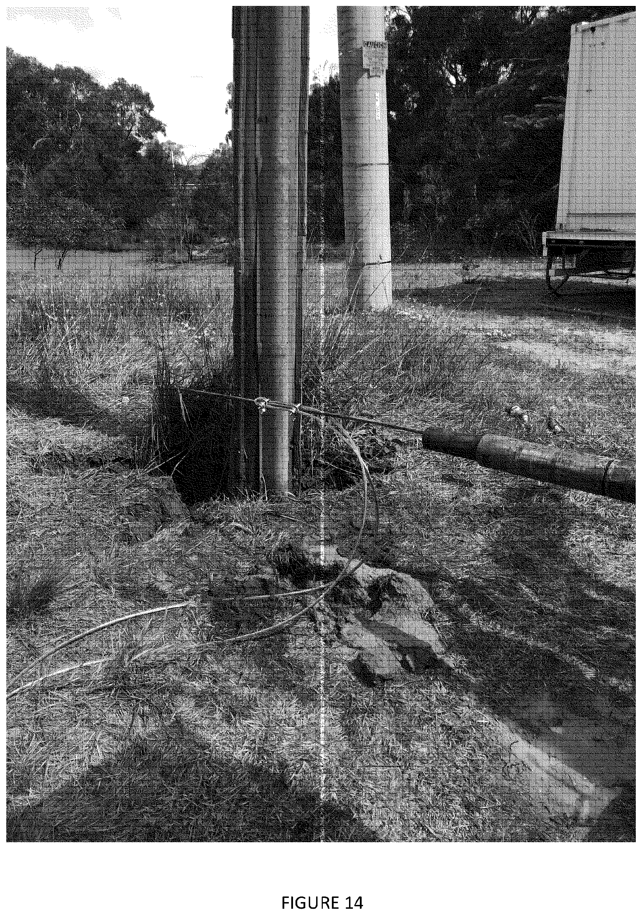

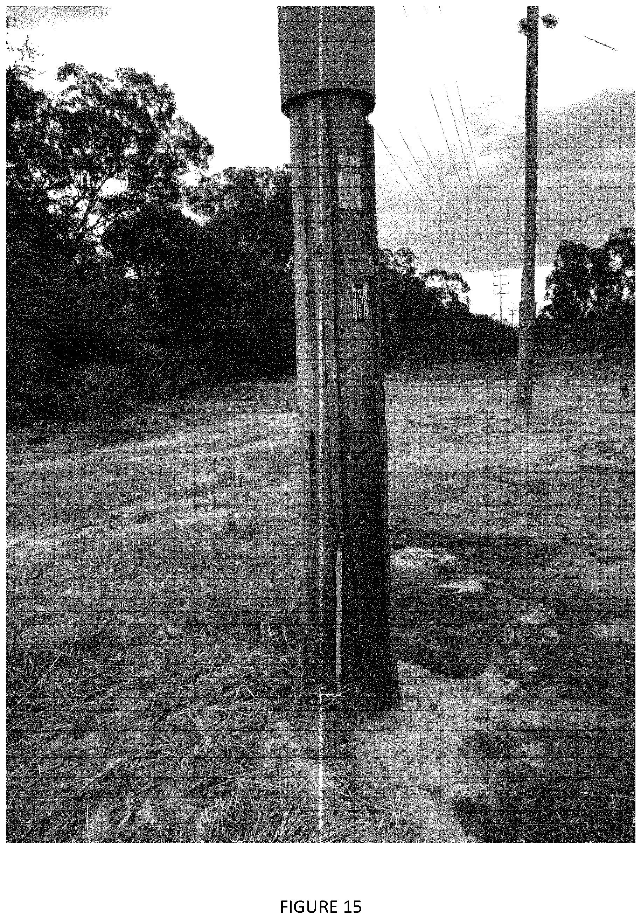

With reference to Figure 7, there may also not be enough exposed ground 10 to provide for installation of multiple vertical-type earthing electrodes. However, particularly in situations wherein one or more ground layers are difficult to dig through, multiple prior art vertical electrodes may need to be installed to achieve the desired total electrical resistance. In such a scenario, an embodiment of the present invention may also be advantageous in that the borehole can be dug under pre-existing infrastructure or other surface features (such as example buildings 30A & 30B), enabling installation of sufficient length of earthing electrode 22 to achieve a target total electrical resistance where multiple vertical electrodes are impractical or impossible. See also the photographs of Figures 10-15, depicting installation of an earthing electrode using an embodiment of the method of the present invention without disturbing an already-present power pole. In particular, Figures 10 & 13-15 depict the borehole being dug, drill mud being extracted, the earthing electrode being installed and the final result, all without the power pole being disturbed.

### Multiple Boreholes and Expansion of Existing Networks

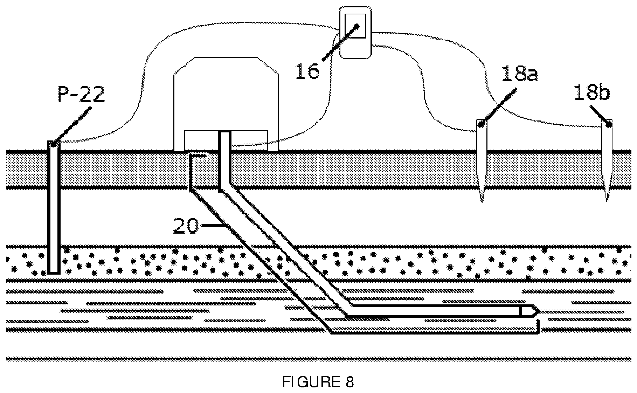

Existing earthing systems require maintenance, checking, replacement and occasionally extension or expansion, particularly if the associated electrical system or network being earthed has grown since installation or the resistivity characteristics of the ground have worsened (such as through soil leaching or contamination). An embodiment of the method may be able to be used to expand an existing earthing system. With reference to Figure 8, when the method is used in such a manner, total electrical resistance may be determined as the electrical resistance measured between each of an earthing electrode of the existing earthing system P-22 and the submerged portion 20 of the drill string 12, and the test electrode or electrodes 18a,b.

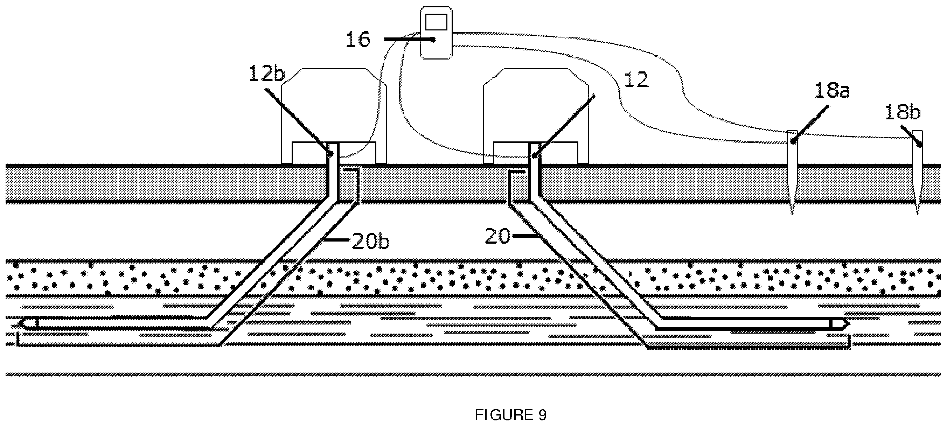

The total electrical resistance measured between the submerged portion 20 of the drill string 12 and the test electrode or electrodes 18a,b, may not reach the target total electrical resistance. In some embodiments, it may be necessary to expand the electrical earthing system by installing further earth electrodes. In an embodiment and with reference to Figure 9, if by step 6, the total electrical resistance does not reach the target total electrical resistance, steps 1 - 6 may be repeated to drill a further borehole in the region of ground for a further earthing electrode to be installed within the further borehole before being backfilled with ground material. In at least one embodiment wherein there is a further borehole being drilled, total electrical resistance is electrical resistance measured between each of a conductive element in the first borehole and a further conductive element in the further borehole and the test electrode or electrodes. This so that the total performance of the earthing system may be determined.

In an embodiment wherein Step 7 is not yet executed for the first borehole (i.e. a further borehole is being drilled either concurrently with the first borehole, or otherwise before the drill string 12 is removed from the first borehole) then the conductive element is the submerged portion 20 of the drill string 12, and the further conductive element is a submerged portion 20b of a further drill string 12b. This is the particular embodiment depicted in Figure 9.

In an alternate embodiment wherein Step 7 is executed with regards to the first borehole, the conductive element is the earthing electrode installed within the electrode and the further conductive element is a submerged portion of the drill string within the further borehole.

While the invention has been described with reference to preferred embodiments above, it will be appreciated by those skilled in the art that it is not limited to those embodiments, but may be embodied in many other forms, variations and modifications other than those specifically described. The invention includes all such variation and modifications. The invention also includes all of the steps, features, components and/or devices referred to or indicated in the specification, individually or collectively and any and all combinations or any two or more of the steps or features.

In this specification, unless the context clearly indicates otherwise, the word "comprising" is not intended to have the exclusive meaning of the word such as "consisting only of", but rather has the non-exclusive meaning, in the sense of "including at least". The same applies, with corresponding grammatical changes, to other forms of the word such as "comprise", etc.

Other definitions for selected terms used herein may be found within the detailed description of the invention and apply throughout. Unless otherwise defined, all other scientific and technical terms used herein have the same meaning as commonly understood to one of ordinary skill in the art to which the invention belongs.

Any promises made in the present document should be understood to relate to some embodiments of the invention, and are not intended to be promises made about the invention in all embodiments. Where there are promises that are deemed to apply to all embodiments of the invention, the applicant/patentee reserves the right to later delete them from the description and they do not rely on these promises for the acceptance or subsequent grant of a patent in any country. The scope of the invention is defined by the appended claims that follow:

## Claims

1. A method of installing an electrical earthing system in a region of ground, comprising the steps of:
(I) determining a borehole site in the region of ground (10);
(II) providing a drill string (12) comprised of a conductive material and having a drill bit (14) at an end thereof, and electrically connecting the drill string to an earth test terminal of a resistance testing apparatus (16);
(III) electrically connecting a test electrode or electrodes (18a,b) to a remaining terminal or terminals of the resistance testing apparatus (16) and placing the test electrode or electrodes (18a,b) in or on the ground (10) within an area around the borehole;
(IV) drilling the borehole using the drill string (12);
(V) periodically or continuously measuring and recording a total electrical resistance using the resistance testing apparatus (16), and adjusting the drill string (12) to reduce the total electrical resistance towards a target total electrical resistance;
(VI) removing the drill string (12) from the borehole and disconnecting the drill string (12) from the resistance testing apparatus (16);
(VII) installing an earthing electrode (22) within the borehole; and
(VIII) backfilling the borehole with backfill ground material;
wherein the total electrical resistance, measured in step (V), is measured between an entire submerged portion (20) of the drill string (12), using as electrode substantially an entire length of the drill string (12) that is submerged underground, and the test electrode or electrodes (18a,b).

2. The method of claim 1, wherein:
if, by step (VI), the total electrical resistance does not reach the target total electrical resistance, steps (I) - (VI) are repeated to drill a further borehole in the region of ground (10);
a further earthing electrode (22) is installed within the further borehole, which is then backfilled with ground material;
total electrical resistance is electrical resistance measured between:
(a) each of a conductive element in the first borehole and a further conductive element in the further borehole; and
(b) the test electrode or electrodes (18a,b);
the conductive element is either the earthing electrode (22) installed within the electrode or the submerged portion (20) of the drill string (12), depending on if Step (VII) is executed for the borehole; and
the further conductive element is either a submerged portion (20) of the drill string (12) within the further borehole, or a submerged portion (20b) of a further drill string (12b), depending on if Step (VII) is executed for the borehole.

3. The method of claim 1 or claim 2, wherein the step of determining the borehole site comprises:
(I) using the resistance testing apparatus (16) to test ground electrical resistance at a plurality of sites within the region;
(II) using the ground electrical resistance to identify, from the plurality of sites within the region, at least one qualifying site; and
(III) selecting the borehole site from the at least one qualifying site or sites;
wherein the qualifying or sites are identified by having favourable resistivity characteristics relative to other sites of the plurality of sites.

4. The method of claim 3, wherein the borehole site is selected as the site having the most favourable resistivity characteristics of the plurality of sites.

5. The method of any one of the above claims 1-4, wherein the drill bit (14) is a directional drill bit; and
during Step (IV), a direction of the drill bit (14) is adjustable such that the borehole is able to be drilled to comprise consecutive portions thereof extending non-parallel to one another.

6. The method of claim 5, wherein the borehole extends through a ground layer at an angle between -45° and +45° relative to horizontal (0°) for at least a portion of a length thereof.

7. The method of claim 5 or 6, wherein the borehole is drilled such that at least a portion of a length of the borehole extends approximately parallel to a ground layer.

8. The method of claim 7, wherein the ground layer is a region of in situ ground material having favourable resistivity characteristics.

9. The method of any one of the above claims 1-8, wherein ground material extracted from the borehole during drilling is retained for use as least a portion of the backfill ground material.

10. The method of any one of the above claims 1-9, wherein the borehole is filled with backfill ground material and one or more additives.

11. The method of any one of the above claims 1-10, when used to expand an existing earthing system, wherein total electrical resistance is the electrical resistance measured between:
(a) each of an earthing electrode (P-22) of the existing earthing system and the submerged portion (20) of the drill string (12); and
(b) the test electrode or electrodes (18a,b).

12. The method of any one of the above claims 1-11, wherein in the step (V), adjusting the drill string (12) is performed by re-angling or relocating said drill string (12), for reducing the total electrical resistance, directing the drill string (12) to ground layers having favourable resistivity characteristics and circumventing ground layers having unfavourable resistivity characteristics.

## Patentansprüche

1. Verfahren zur Installation eines elektrischen Erdungssystems in einer Region des Bodens, das die folgenden Schritte umfasst:
(I) Bestimmen eines Bohrlochstandortes in der Region des Bodens (10);
(II) Bereitstellen eines Bohrstrangs (12), der ein leitfähiges Material umfasst und mit einer Bohrkrone (14) an einem Ende davon versehen ist, und elektrisches Verbinden des Bohrstrangs mit einem Erdprüfanschluss eines Widerstandsprüfungsgeräts (16);
(III) elektrisches Verbinden einer Prüfelektrode oder von Prüfelektroden (18a,b) mit einem verbleibenden Anschluss oder Anschlüssen des Widerstandsprüfungsgeräts (16) und Platzieren der Prüfelektrode oder der Prüfelektroden (18a,b) im oder auf dem Boden (10) innerhalb eines Bereichs um das Bohrloch;
(IV) Bohren des Bohrlochs unter Verwendung des Bohrstrangs (12);
(V) periodisches oder kontinuierliches Messen und Aufzeichnen eines elektrischen Gesamtwiderstands unter Verwendung des Widerstandsprüfungsgeräts (16) und Einstellen des Bohrstrangs (12), um den elektrischen Gesamtwiderstand in Richtung eines elektrischen Zielgesamtwiderstands zu reduzieren;
(VI) Entfernen des Bohrstrangs (12) aus dem Bohrloch und Trennen des Bohrstrangs (12) von dem Widerstandsprüfungsgerät (16);
(VII) Installieren einer Erdungselektrode (22) innerhalb des Bohrlochs; und (VIII) Verfüllen des Bohrlochs mit Verfüllbodenmaterial;
wobei der in Schritt (V) gemessene elektrische Gesamtwiderstand zwischen einem gesamten untergetauchten Abschnitt (20) des Bohrstrangs (12), wobei als Elektrode im Wesentlichen eine gesamte Länge des Bohrstrangs (12) verwendet wird, der in den Untergrund eingetaucht ist, und der Prüfelektrode oder den Prüfelektroden (18a, b) gemessen wird.

2. Verfahren nach Anspruch 1, wobei:
falls bei Schritt (VI) der elektrische Gesamtwiderstand nicht den elektrischen Zielgesamtwiderstand erreicht, die Schritte (I) - (VI) wiederholt werden, um ein weiteres Bohrloch in der Region des Bodens (10) zu bohren;
eine weitere Erdungselektrode (22) innerhalb des weiteren Bohrlochs installiert wird, das dann mit Bodenmaterial vergefüllt wird;
wobei der elektrische Gesamtwiderstand der elektrische Widerstand ist, gemessen zwischen:
(a) jeweils einem leitfähigen Element in dem ersten Bohrloch und einem weiteren leitfähigen Element in dem weiteren Bohrloch; und
(b) der Prüfelektrode oder den Prüfelektroden (18a, b);
das leitfähige Element entweder die innerhalb der Elektrode installierte Erdungselektrode (22) oder der untergetauchte Abschnitt (20) des Bohrstrangs (12) ist, je nachdem, ob Schritt (VII) für das Bohrloch ausgeführt wird; und
das weitere leitfähige Element entweder ein untergetauchter Abschnitt (20) des Bohrstrangs (12) innerhalb des weiteren Bohrlochs oder ein untergetauchter Abschnitt (20b) eines weiteren Bohrstrangs (12b) ist, je nachdem, ob Schritt (VII) für das Bohrloch ausgeführt wird.

3. Verfahren nach Anspruch 1 oder Anspruch 2, wobei der Schritt des Bestimmens des Bohrlochstandortes Folgendes umfasst:
(I) Verwenden des Widerstandsprüfungsgeräts (16) zum Prüfen des elektrischen Bodenwiderstands an einer Vielzahl von Standorten innerhalb der Region;
(II) Verwenden des elektrischen Bodenwiderstands, um aus der Vielzahl von Standorten innerhalb der Region mindestens einen qualifizierenden Standort zu identifizieren; und
(III) Auswählen des Bohrlochstandortes aus dem mindestens einen qualifizierenden Standort oder Standorten;
wobei die qualifizierenden Standorte dadurch identifiziert werden, dass sie im Vergleich zu anderen Standorten der Vielzahl von Standorten günstige Widerstandseigenschaften aufweisen.

4. Verfahren nach Anspruch 3, wobei der Bohrlochstandort als der Standort mit den günstigsten Widerstandseigenschaften aus der Vielzahl der Standorte ausgewählt wird.

5. Verfahren nach einem der vorhergehenden Ansprüche 1-4, wobei die Bohrkrone (14) eine Richtungsbohrkrone ist; und
während Schritt (IV) eine Richtung der Bohrkrone (14) derart einstellbar ist, dass das Bohrloch so gebohrt werden kann, dass es aufeinanderfolgende Abschnitte davon umfasst, die nicht parallel zueinander verlaufen.

6. Verfahren nach Anspruch 5, wobei das Bohrloch mindestens über einen Teil seiner Länge in einem Winkel zwischen -45° und +45° relativ zur Horizontalen (0°) durch eine Bodenschicht verläuft.

7. Verfahren nach Anspruch 5 oder 6, wobei das Bohrloch derart gebohrt wird, dass mindestens ein Teil einer Länge des Bohrlochs annähernd parallel zu einer Bodenschicht verläuft.

8. Verfahren nach Anspruch 7, wobei die Bodenschicht eine Region aus Insitu-Bodenmaterial mit günstigen Widerstandseigenschaften ist.

9. Verfahren nach einem der vorhergehenden Ansprüche 1-8, wobei das während des Bohrens aus dem Bohrloch entnommene Bodenmaterial zur Verwendung als mindestens ein Teil des Verfüllbodenmaterials zurückgehalten wird.

10. Verfahren nach einem der vorhergehenden Ansprüche 1-9, wobei das Bohrloch mit Verfüllbodenmaterial und einem oder mehreren Zusatzstoffen gefüllt wird.

11. Verfahren nach einem der obigen Ansprüche 1-10, wenn es verwendet wird, um ein bestehendes Erdungssystem zu erweitern, wobei der elektrische Gesamtwiderstand der elektrische Widerstand ist, gemessen zwischen:
(a) jeweils einer Erdungselektrode (P-22) des bestehenden Erdungssystems und dem untergetauchten Abschnitt (20) des Bohrstrangs (12); und
(b) der Prüfelektrode oder den Prüfelektroden (18a, b).

12. Verfahren nach einem der vorhergehenden Ansprüche 1-11, wobei in dem Schritt (V) das Einstellen des Bohrstrangs (12) durch Neuausrichten oder Umlagern des Bohrstrangs (12) durchgeführt wird, um den elektrischen Gesamtwiderstand zu reduzieren, den Bohrstrang (12) auf Bodenschichten mit günstigen Widerstandseigenschaften zu richten und Bodenschichten mit ungünstigen Widerstandseigenschaften zu umgehen.

## Revendications

1. Procédé d'installation d'un système de mise à la terre électrique dans une région de sol, comprenant les étapes consistant à :
(I) déterminer un site de trou de forage dans la région de sol (10) ;
(II) fournir un train de tiges (12) constitué d'un matériau conducteur et ayant un trépan (14) au niveau d'une extrémité de celui-ci, et connectant électriquement le train de tiges à une borne d'essai de terre d'un appareil de test de résistance (16) ;
(III) connecter électriquement une électrode ou des électrodes de test (18a,b) à une borne ou des bornes restantes de l'appareil de test de résistance (16) et placer l'électrode ou les électrodes de test (18a,b) dans ou sur le sol (10) au sein d'une zone entourant le trou de forage ;
(IV) percer le trou de forage à l'aide du train de tiges (12) ;
(V) mesurer et enregistrer périodiquement ou continuellement une résistance électrique totale à l'aide de l'appareil de test de résistance (16), et ajuster le train de tiges (12) pour réduire la résistance électrique totale vers une résistance électrique totale cible ;
(VI) retirer le train de tiges (12) du trou de forage et déconnecter le train de tiges (12) de l'appareil de test de résistance (16) ;
(VII) installer une électrode de mise à la terre (22) au sein du trou de forage ; et (VIII) remblayer le trou de forage avec des matériaux de sol de remblai ;
dans lequel la résistance électrique totale, mesurée à l'étape (V), est mesurée entre une partie immergée (20) entière du train de tiges (12), à l'aide, en guise d'électrode, de sensiblement une longueur entière du train de tiges (12) qui est immergé sous le sol, et l'électrode ou les électrodes de test (18a,b).

2. Procédé selon la revendication 1, dans lequel :
si, à l'étape (VI), la résistance électrique totale n'atteint pas la résistance électrique totale cible, les étapes (I) à (VI) sont répétées pour percer un trou de forage supplémentaire dans la région de sol (10) ;
une électrode de mise à la terre (22) supplémentaire est installée au sein du trou de forage supplémentaire, qui est ensuite remblayé avec du matériau de sol ;
la résistance électrique totale est la résistance électrique mesurée entre :
(a) chacun d'un élément conducteur dans le premier trou de forage et d'un élément conducteur supplémentaire dans le trou de forage supplémentaire ; et
(b) l'électrode ou les électrodes de test (18a,b) ;
l'élément conducteur est soit l'électrode de mise à la terre (22) installée au sein de l'électrode, soit la partie immergée (20) du train de tiges (12), en fonction de l'exécution de l'étape (VII) pour le trou de forage ; et
l'élément conducteur supplémentaire est soit une partie immergée (20) du train de tiges (12) au sein du trou de forage supplémentaire, soit une partie immergée (20b) d'un train de tiges supplémentaire (12b), en fonction de l'exécution de l'étape (VII) pour le trou de forage.

3. Procédé selon la revendication 1 ou la revendication 2, dans lequel l'étape de détermination du site de trou de forage comprend :
(I) l'utilisation de l'appareil de test de résistance (16) pour tester la résistance électrique de sol au niveau d'une pluralité de sites au sein de la région ;
(II) l'utilisation de la résistance électrique du sol pour identifier, parmi la pluralité de sites au sein de la région, au moins un site qualifiant ; et
(III) la sélection du site de forage parmi l'au moins un site ou les sites qualifiants ;
dans lequel les sites qualifiants sont identifiés par le fait d'avoir des caractéristiques de résistivité favorables par rapport à d'autres sites de la pluralité de sites.

4. Procédé selon la revendication 3, dans lequel le site de trou de forage est sélectionné en guise de site ayant les caractéristiques de résistivité les plus favorables de la pluralité de sites.

5. Procédé selon l'une quelconque des revendications 1 à 4 ci-dessus, dans lequel le trépan (14) est un trépan directionnel ; et
au cours de l'étape (IV), une direction du trépan (14) est ajustable de telle sorte que le trou de forage est apte à être percé pour comprendre des parties consécutives de celui-ci s'étendant de manière non parallèle les unes aux autres.

6. Procédé selon la revendication 5, dans lequel le trou de forage s'étend à travers une couche de sol à un angle compris entre -45 ° et +45 ° par rapport à l'horizontale (0°) pour au moins une partie de la longueur de celui-ci.

7. Procédé selon la revendication 5 ou 6, dans lequel le trou de forage est percé de telle sorte qu'au moins une partie d'une longueur du trou de forage s'étend approximativement parallèlement à une couche de sol.

8. Procédé selon la revendication 7, dans lequel la couche de sol est une région de matériau de sol in situ ayant des caractéristiques de résistivité favorables.

9. Procédé selon l'une quelconque des revendications 1 à 8 ci-dessus, dans lequel le matériau de sol extrait du trou de forage pendant le perçage est conservé pour être utilisé en guise d'au moins une partie du matériau de sol de remblai.

10. Procédé selon l'une quelconque des revendications 1 à 9 ci-dessus, dans lequel le trou de forage est rempli d'un matériau de remblai et d'un ou plusieurs additifs.

11. Procédé selon l'une quelconque des revendications 1 à 10 ci-dessus, lorsqu'il est utilisé pour étendre un système de mise à la terre existant, dans lequel la résistance électrique totale est la résistance électrique mesurée entre :
(a) chacune d'une électrode de mise à la terre (P-22) du système de mise à la terre existant et la partie immergée (20) du train de tiges (12) ; et
(b) l'électrode ou les électrodes de test (18a,b).

12. Procédé selon l'une quelconque des revendications 1 à 11 ci-dessus, dans lequel dans l'étape (V), l'ajustement du train de tiges (12) s'effectue en réorientant ou en relocalisant ledit train de tiges (12), pour réduire la résistance électrique totale, dirigeant le train de tiges (12) vers des couches de sol ayant des caractéristiques de résistivité favorables et contournant des couches de sol ayant des caractéristiques de résistivité défavorables.
